# FASCICULE DE BREVET EUROPEEN

(11) **EP 0 432 046 B1**
(45) Date de publication et mention de la délivrance du brevet: **13.07.1994**
(21) Numéro de dépôt: 90403472.5
(22) Date de dépôt: 06.12.1990
(51) Int. Cl.: H05K 5/00

(54) **Boîtier d'encapsulation pour composant électronique**
Verkapselungsgehäuse für elektronischen Baustein
Encapsulating housing for electronic component

(30) Priorité: 08.12.1989 FR 8916267
(43) Date de publication de la demande: 12.06.1991
(73) Titulaire: COMPAGNIE EUROPEENNE DE COMPOSANTS ELECTRONIQUES LCC, F-92400 Courbevoie (FR)
(72) Inventeur: Pageaud, Michel, F-92045 Paris La Défense (FR); Dautriche, Michel, F-92045 Paris La Défense (FR)
(74) Mandataire: Guérin, Michel

(56) Documents cités:
- EP-A- 0 324 439
- DE-A- 3 130 837
- US-A- 3 484 536
- US-A- 3 838 316

## Description

La présente invention concerne un boîtier pour l'encapsulation de composants électroniques et notamment de condensateurs.

Les condensateurs réalisés selon une méthode connue, par exemple, en empilant successivement des feuilles de films métallisés, nécessitent une protection extérieure afin d'améliorer leur résistance aux chocs et de leur donner un meilleur aspect extérieur.

Généralement la mise sous boîtier de composants, du type condensateurs, consiste à introduire le composant muni de deux fils de connexion dans un boîtier ayant une face ouverte. On remplit le boîtier avant ou après l'introduction du composant de résine liquide solidifiable. Les fils de connexion sortent du boîtier vers le haut. La résine comble l'espace libre entre le boîtier et le composant. En se solidifiant elle maintient solidement le composant dans le boîtier.

Les boîtiers utilisés peuvent avoir une forme de parallélépipède rectangle et comporter un fond rectangulaire, deux petites faces latérales, deux grandes faces latérales et une seule face opposée au fond ouverte.

On encapsule dans ce genre de boîtier des composants en forme de parallélépipède rectangle, comportant deux fils de connexion fixés dans la partie centrale des petites faces latérales.

Les dimensions du boîtier sont ajustées à celle du composant dans un souci de moindre encombrement.

Le boîtier comporte également des moyens de guidage des fils de connexion du composant. Ces moyens de guidage sont situés à l'intérieur du boîtier sur ses faces latérales. Leur forme permet l'introduction du composant par un mouvement sensiblement vertical dirigé de haut en bas si le boîtier est posé sur son fond. Lorsque les fils de connexion sont situés sur les petites faces latérales du composant, dans leur partie centrale, les moyens de guidage sont situés, de préférence, dans la partie centrale des petites faces latérales du boîtier. Il y a autant de moyens de guidage que de fils de connexion.

Pour encapsuler de tels composants de manière automatique, à cadence élevée, on peut fixer les fils de connexion des composants sur une bande de transport verticale, le composant étant placé en bas de la bande. On présente sous chaque composant un boîtier posé sur son fond, sa face ouverte vers le haut. Pour introduire le composant dans le boîtier par un mouvement sensiblement vertical de haut en bas, il faut que le composent soit aligné avec le boîtler. Les faces latérales du boîtier doivent être parallèles aux faces latérales du composant. Mais ce n'est pas suffisant.

Il faut aussi que chaque fil de connexion soit aligné avec un moyen de guidage. Las faces latérales du boîtier portant les moyens de guidage doivent être parallèles aux faces latérales du composant portant les fils de connexion, si le composant et le boîtier ont les structures décrites plus haut.

On utilise pour cela un bol vibrant qui distribue les boîtiers et les oriente tous, de manière à ce que les moyens de guidage soient alignés avec les fils de connexion. Cette orientation se fait par repérage des petites faces latérales ou des grandes faces latérales.

Afin d'optimiser le volume capacitif de condensateurs empilés, on a été amené à réaliser des condensateurs avec des feuilles de film métallisé carrées.

Comme on est toujours à la recherche de place sur les circuits imprimés sur lesquels on monte des condensateurs, on a envisagé de les encapsuler dans des boîtiers à fond carré. Ces boîtiers à fond carré sont conçus comme les boîtiers traditionnels à fond rectangulaire, avec autant de moyens de guidage des fils de connexion que de fils de connexion du composant. On peut encapsuler dans ces boîtiers à fond carré des condensateurs et d'autres composants.

Le boîtier ayant un fond carré, ses faces latérales sont égales. Le bol vibrant ne peut détecter la position des moyens de guidage et ne peut distribuer les boîtiers orientés convenablement.

Ces boîtiers ne peuvent être insérés dans une chaîne classique d'encapsulation automatisée à cadence rapide.

Le brevet allemand DE-A-31 30837 décrit un boîtier pour composant comportant un fond à quatre angles droits et quatre faces latérales. Deux faces latérales en vis à vis comportent chacune des moyens de guidage des fils de connexion du composant. Ce boîtier possède les inconvénients mentionnés ci-dessus c'est à dire : encombrement si son fond est rectangulaire et impossibilité de l'insérer dans une chaîne d'encapsulation automatisée à cadence rapide si son fond est carré.

La présente invention vise à remédier à ces inconvénients. Le but de l'invention est de proposer un boîtier dont les faces latérales sont égales et comportent toutes des moyens de guidage disposés de manière à éviter l'orientation du boîtier par rapport au composant.

La présente invention propose un boîtier pour l'encapsulation d'un composant électronique comportant un fond et des faces latérales portant des moyens de guidage de fils de connexion du composant, disposées autour d'un axe principal du boîtier caractérisé en ce que le fond a des côtés tous égaux et en ce que les faces latérales comportent toutes des moyens de guidage, les moyens de guidage étant répartis régulièrement autour de l'axe principal du boîtier.

Selon une autre caractéristique, chaque face latérale comporte au moins un pied de lavage. Les pieds de lavage sont répartis régulièrement autour de l'axe principal du boîtier.

Les moyens de guidage sont placés à l'intérieur du boîtier.

Les moyens de guidage peuvent être placés dans la partie centrale des faces latérales ou au niveau d'arêtes séparant deux faces latérales successives. Les moyens de guidage peuvent être réalisés par une rainure.

Les pieds de couplage forment des saillies qui prolongent les faces latérales au-delà d'une face ouverte du boîtier opposée à son fond.

Dans un mode de réalisation préféré le boîtier est parallélépipèdique, à fond en forme de carré.

Le boîtier est réalisé en matériau thermoplastique par moulage.

L'invention sera mieux comprise et d'autres avantages apparaîtront à la lecture de la description détaillée qui suit et qui est faite en référence aux dessins annexés dans lesquels :
- la figure 1 représente une vue de dessus d'un boîtier traditionnel posé sur son fond ;
- la figure 2 est une coupe selon l'axe AA de la figure 1 ;
- la figure 3 représente partiellement un boîtier traditionnel recevant un condensateur ;
- la figure 4 représente une vue de dessus d'un boîtier, conforme à l'invention, posé sur son fond ;
- la figure 5 est une coupe selon l'axe BB de la figure 4 ;
- la figure 6 représente partiellement un boîtier, selon l'invention, recevant un condensateur ; sur ces figures les mêmes repères représentent les mêmes éléments.

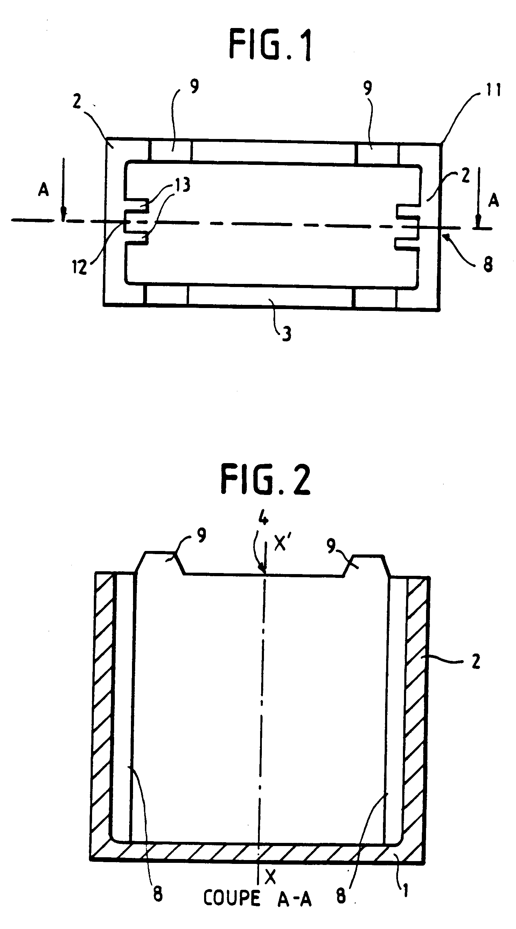

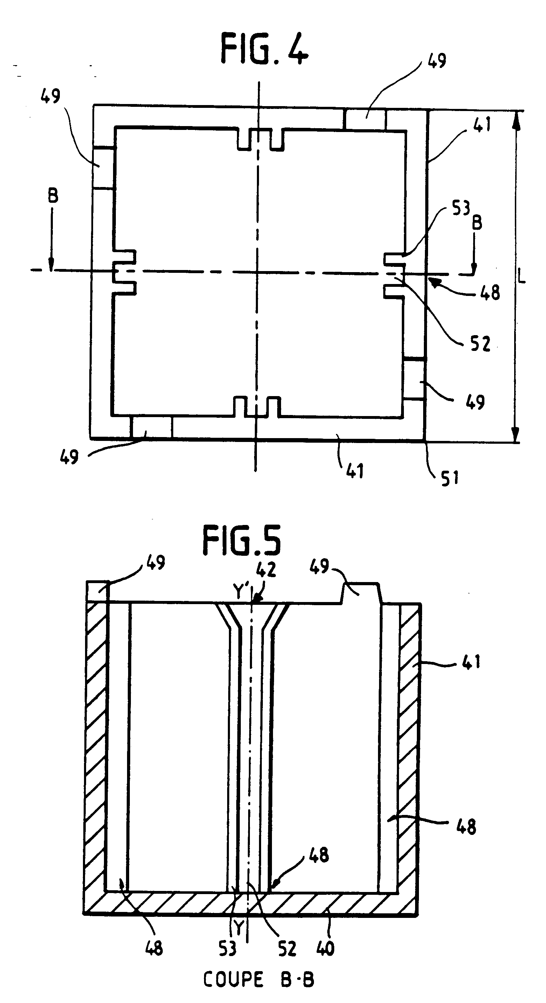

La boîtier traditionnel représenté sur les figures 1 à 3 a la forme d'un parallélépipède rectangle. Il comporte un fond 1, quatre faces latérales 2,3. La dernière face 4 du parallélépipède est ouverte et est dirigée vers le haut lorsque le boîtier est posé sur son fond 1. Les faces 2 sont des petites faces, les faces 3 sont des grandes faces. Les faces latérales sont disposées autour d'un axe principal XX′ du boîtier qui est transversal au fond 1.

Ce boîtler est destiné à protéger un composant électronique 10 tel qu'un condensateur constitué d'un empilement de films métallisés, par exemple. Le composant 10 a la forme d'un parallélépipède rectangle. Il porte deux fils de connexion 5 fixés par une extrémité, sur deux faces opposées ; ici il s'agit de deux petites faces opposées 6. L'autre extrémité des fils est destinée à être reliée à un circuit électronique. Ces deux fils de connexion 5 sont sensiblement parallèles. On a représenté sur chaque fil 5, une partie 7 sensiblement en saillie par rapport au composant 10. Cette partie en saillie 7 est proche de l'extrémité du fil qui est solidaire du composant 10. Lorsque l'on introduit le composant 10 dans le boîtier, les parties 7 en saillie sont en contact avec l'intérieur du boîtier.

On s'arrange pour que les dimensions du boîtier soient ajustées à celles du composant 10 muni de ses fils de connexion 5, pour réduire l'encombrement.

Le boîtier comporte des moyens de guidage 8 des fils de connexion du composant 10. Il y en a autant que de fils de connexion 5. Ces moyens de guidage 8 sont placés à l'intérieur du boîtier sur ses faces latérales 2,3. La forme des moyens de guidage 8 permet l'introduction du composant 10 dans le boîtier par un mouvement dirigé selon l'axe principal XX′ du boîtier.

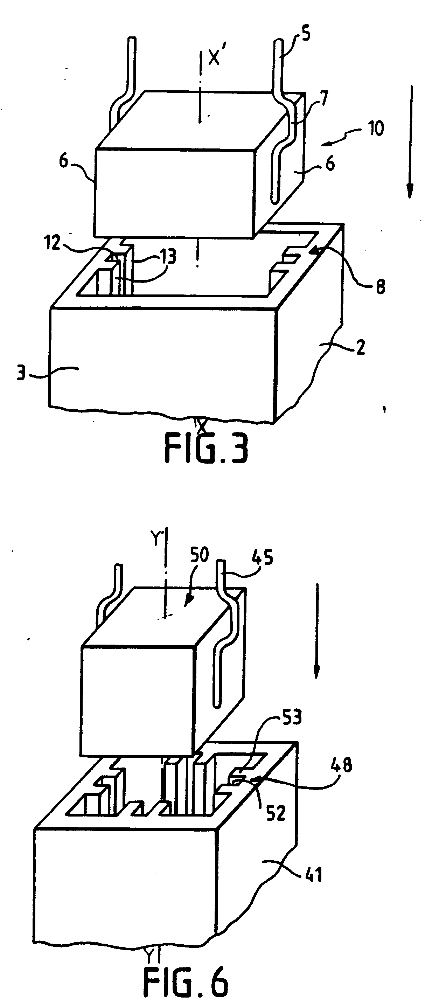

Sur les figures 1 et 2, les moyens de guidage 8 sont des rainures 12, à côtés sensiblement parallèles, disposées sensiblement le long de l'axe principal XX′, du fond 1 vers la face ouverte 4. On les a représentées dans la partie centrale des petites faces latérales 2 du boîtier. Chaque fil de connexion 5 vient s'encastrer dans une rainure 12 et la partie en saillie 7 est bien en contact avec la face latérale 2. Sur les figures 1 et 3 on remarque que chaque rainure 12 est limitée par deux moulures 13 placées à l'intérieur du boîtier à la surface de chaque face latérale 2. On pourrait envisager que les rainures 12 soient creusées à l'intérieur des faces latérales 2.

Le boîtier est rempli, avant ou après l'introduction du composant 10, d'une résine liquide solidifiable. Cette résine remplit tout l'espace libre entre le boîtier et le composant 10. Une fois solidifiée la résine maintient définitivement et solidement le composant dans le boîtier.

Le boîtier comporte en outre des pieds de lavage 9. Les pieds de lavage forment des saillies qui prolongent les grandes faces latérales 3 du boîtier au-delà de la face ouverte 4. On a représenté deux pieds de lavage 9 par grande face latérale 3.

Sur la figure 3, les pieds de lavage 9 n'ont pas été représentés par souci de clarté.

Lorsque le composant est monté sur un circuit imprimé, ce sont les pieds de lavage 9 qui reposent sur le circuit. Ces pieds de lavage 9 surélèvent le composant par rapport au circuit, de manière à laisser circuler le bain de soudure et le liquide de nettoyage que l'on utilise classiquement lors du montage de composants sur un circuit imprimé.

Les pieds de lavage 9 sont suffisamment éloignés d'arêtes 11 séparant deux faces latérales 2,3 successives du boîtier pour éviter que la résine ne remonte par capillarité le long des pieds de lavage 9. Des amas de résine solidifiée sur les pieds de lavage 9 empêcheraient un montage correct du boîtier sur le circuit imprimé.

Des boîtiers de ce type sont réalisés dans une matière thermoplastique, par moulage par injection par exemple. Les moyens de guidage 8 et les pieds de lavage 9 sont moulés en même temps.

On va décrire maintenant une opération d encapsulation.

Les composants 10 sont généralement maintenus par leurs fils de connexion 5 sur une bande verticale, les composants 10 étant disposés vers le bas de la bande. On présente sous chaque composant 10, un boîtier posé sur son fond 1 et on aligne le boîtier et le composant 10 de manière à ce que les faces latérales du boîtier soient parallèles aux faces latérales du composant. Mais ce n'est pas suffisant, il faut aussi orienter le boîtier par rapport au composant de manière à ce que les moyens de guidage 8 soient alignés avec les fils de connexion 5. Pour cela les grandes faces latérales 3 et les petites faces latérales 2 du boîtier doivent être respectivement parallèles aux grandes faces latérales et aux petites faces latérales du composant 10.

Cette orientation peut se faire en utilisant un bol vibrant, par exemple. Des boîtiers sont placés dans le bol et en sortent en glissant dans un dispositif approprié, le long de leur petite face latérale, par exemple.

Les figures 4, 5 représentent respectivement en vue de dessus et en coupe, un mode de réalisation d'un boîtier selon l'invention.

Le boîtier comporte un fond 40, des faces latérales 41 disposées autour d'un axe principal YY′ du boîtier, une face 42 ouverte et opposée au fond.

Le boîtier est représenté posé sur son fond 40 sur la figure 5. Les principales différences avec le boîtier traditionnel résident au niveau des faces latérales 41 et du fond 40. Le fond 40 du boîtier a des côtés égaux. Les faces latérales 41 ont toutes la même largeur L. Sur la figure 4, on voit que le boîtier est parallélépipèdique à fond 40 carré.

On se réfère maintenant à la figure 6. Ce boîtier est destiné à encapsuler un composant 50 comparable à celui représenté à la figure 3 mais avec une section droite carrée.

Les dimensions du boîtier sont ajustées à celles du composant 50. Ce composant 50 est muni, de manière classique, de fils de connexions 45 fixés sur deux faces latérales opposées dans leurs parties centrales. Ces fils de connexion 45 sont comparables à ceux décrits précédemment.

Toutes les faces latérales 41 du boîtler comportent des moyens de guidage 48 des fils de connexion 45. Les moyens de guidage 48 sont placés à l'intérieur du boîtier. Ils sont répartis régulièrement autour de l'axe YY′.

On a représenté autant de moyens de guidage 48 que de faces latérales 41. Il pourrait y en avoir plus. On les a représentés dans la partie centrale de chaque face latérale 41 mais ce n'est qu'un exemple de réalisation.

Les moyens de guidage 48 ont une forme appropriée pour permettre l'introduction du composant 50 par un mouvement du boîtler et/ou du composant 50 selon l'axe principal YY′. Si le boîtier est posé sur son fond 40, on pourra déplacer le composant 50 sensiblement verticalement de haut en bas.

On a réalisé les moyens de guidage 48 sous forme de rainures 52 à côtés sensiblement parallèles. Elles s'étendent le long de l'axe principal YY′, du fond 40 vers la face ouverte 42. Chaque rainure 52 est disposée dans la partie centrale d'une face latérale 41.

On pourrait envisager pour encapsuler des composants d'un autre type ayant, par exemple, des fils de connexions placés sur deux arêtes opposées, que les rainures soient placées dans les coins du boîtier au niveau d'arêtes 51 séparant deux faces latérales 41.

Comme dans le boîtier traditionnel les rainures 52 peuvent être limitées par deux moulures 53 sensiblement parallèles, ces moulures 53 sont disposées à la surface des parois latérales 41. Dans une autre configuration, elles pourraient être creusées dans les faces latérales 41. Au niveau de la face ouverte 42 du boîtier, les rainures 52 prennent une forme d'entonnoir pour faciliter l'introduction des fils de connexion 45 si l'alignement du boîtier et du composant 50 n'est pas parfaitement correct.

Chaque face latérale 41 comporte maintenant au moins un pied de lavage 49. Les pieds de lavage 49 sont, de préférence répartis régulièrement autour de l'axe principal YY′. Chaque pied de lavage 49 forme, comme dans les boîtiers traditionnels, une saillie qui prolonge une face latérale 41 au-delà de la face ouverte 42.

Les pieds de lavage 49 sont de même dimension que ceux utilisés dans les boîtiers traditionnels. Ils jouent le même rôle.

On a représenté un seul pied de lavage 49 par face latérale 41.

Sur la figure 6, les pieds de lavage ne sont pas représentés en vue d'améliorer la clarté de la figure.

Le boîtier est rempli de résine liquide solidifiable avant ou après l'introduction du composant 50. Les pieds de lavage 49 sont suffisamment éloignés des arêtes 51 du boîtier pour éviter que la résine ne remonte par capillarité le long des pieds 49, au-delà de la face ouverte 42.

Un boîtier selon l'invention pourra être réalisé dans un matériau thermoplastique par moulage par injection. Les moyens de guidage 48 et les pieds de lavage 49 pourront être moulés en même temps.

On va décrire maintenant une opération d'encapsulation d'un composant dans un boîtier selon l'invention. Ce n'est qu'un exemple.

Les composants 50 sont maintenus sur une bande verticale par leurs fils de connexion 45. Les composants 50 sont disposés vers le bas de la bande. On présente sous chaque composant 50 un boîtier posé sur son fond 40 et on aligne le boîtier et le composant 50 de manière à ce que les faces latérales 41 du boîtier soient parallèles aux faces latérales du composant 50

Puisque les faces latérales 41 du boîtier ont la même largeur L et qu'elles comportent des moyens de guidage répartis régulièrement autour de l'axe principal YY′, il n'y a plus besoin d'orienter le boîtier par rapport au composant 50. Les moyens de guidage sont tous placés aux mêmes endroits sur les faces latérales 41. Les fils de connexion 45 se trouveront en face des moyens de guidage 48.

Les boîtiers peuvent alors être placés dans un bol vibrant et ils seront distribués dans la position appropriée en glissant par exemple, le long d'une de leur face latérale 41.

La présente invention n'est pas limitée aux boîtiers parallélépipèdiques à fond carré. Le fond peut être en forme de losange. Il peut même avoir plus ou même moins de quatre côtés.

## Revendications

1. Boîtier pour l'encapsulation d'un composant électronique (50) comportant un fond (40), des faces latérales (41) portant des moyens de guidage (48) de fils de connexion (45) du composant (50), disposées autour d'un axe principal du boîtier caractérisé en ce que le fond (40) a des côtés tous égaux et en ce que les faces latérales (41) comportent toutes des moyens de guidage (48), les moyens de guidage (48) étant répartis régulièrement autour de l'axe principal du boîtier.

2. Boîtier selon la revendication 1 caractérisé en ce que chaque face latérale (41) comporte au moins un pied de lavage (49).

3. Boîtier selon la revendication 2 caractérisé en ce que les pieds de lavage (49) sont répartis régulièrement autour de l'axe principal.

4. Boîtier selon l'une des revendications 1 à 3 caractérisé en ce que les moyens de guidage (48) sont placés à l'intérieur du boîtier (50).

5. Boîtier selon l'une des revendications 1 à 4 caractérisé en ce que les moyens de guidage (48) sont disposés dans la partie centrale de chaque face latérale (41).

6. Boîtier selon l'une des revendications 1 à 4 caractérisé en ce que les moyens de guidage (48) sont disposés au niveau d'arêtes (51) séparant deux faces latérales (41) successives.

7. Boîtier selon l'une des revendications 1 à 6 caractérisé en ce que les moyens de guidage ont la forme d'une rainure (52), dirigée le long de l'axe principal du boîtier.

8. Boîtier selon l'une des revendications 2 à 7 caractérisé en ce que les pieds de lavage (49) forment des saillies qui prolongent les faces latérales (41) au-delà d'une face ouverte (42) du boîtier, opposée à son fond (40).

9. Boîtier selon l'une des revendications 2 à 8 caractérisé en ce que les pieds de lavage (49) sont éloignés d'arêtes (51) séparant deux faces latérales (41) successives pour éviter que lorsque le boîtier est rempli d'une résine liquide celle-ci ne remonte par capillarité le long des pieds de lavage (49).

10. Boîtier selon l'une des revendications 1 à 9 caractérisé en ce qu'il est parallélépipèdique, son fond (40) ayant la forme d'un carré ou d'un losange.

11. Boîtier selon l'une des revendications 1 à 10 caractérisé en ce qu'il est réalisé dans un matériau thermoplastique, par moulage.

## Patentansprüche

1. Gehäuse zum Einkapseln eines elektronischen Bauelements (50), mit einem Boden (40) und Seitenflächen (41), die Führungsmittel (48) für Anschlußdrähte (45) des Bauelements (50) um eine Hauptachse des Gehäuses herum verteilt tragen, dadurch gekennzeichnet, daß der Boden (40) lauter gleichlange Seiten besitzt und daß alle Seitenflächen (41) Führungsmittel (48) aufweisen, wobei die Führungsmittel (48) gleichmäßig um die Hauptachse des Gehäuses herum verteilt sind.

2. Gehäuse nach Anspruch 1, dadurch gekennzeichnet, daß jede Seitenfläche (41) mindestens einen Fuß (49) enthält.

3. Gehäuse nach Anspruch 2, dadurch gekennzeichnet, daß die Füße (49) gleichmäßig um die Hauptachse des Gehäuses herum verteilt sind.

4. Gehäuse nach einem der Ansprüche 1 bis 3, dadurch gekennzeichnet, daß die Führungsmittel (48) sich in dem Gehäuse (50) befinden.

5. Gehäuse nach einem der Ansprüche 1 bis 4, dadurch gekennzeichnet, daß die Führungsmittel (48) sich im zentralen Bereich jeder Seitenfläche (41) befinden.

6. Gehäuse nach einem der Ansprüche 1 bis 4, dadurch gekennzeichnet, daß die Führungsmittel (48) sich entlang von Kanten (51) zwischen zwei benachbarten Seitenflächen (41) erstrecken.

7. Gehäuse nach einem der Ansprüche 1 bis 6, dadurch gekennzeichnet, daß die Führungsmittel die Form einer Rinne (52) besitzen, die sich entlang der Hauptachse des Gehäuses erstreckt.

8. Gehäuse nach einem der Ansprüche 2 bis 7, dadurch gekennzeichnet, daß die Füße (49) Vorsprünge bilden, die die Seitenflächen (41) über eine dem Boden (40) gegenüberliegende offene Gehäuseseite (42) hinaus verlängern.

9. Gehäuse nach einem der Ansprüche 2 bis 8, dadurch gekennzeichnet, daß die Füße (49) von den Kanten (51) zwischen zwei benachbarten Seitenflächen (41) entfernt sind, um zu vermeiden, daß beim Füllen des Gehäuses mit einem flüssigen Harz dieses Harz durch Kapillarwirkung entlang der Füße (49) nach oben steigt.

10. Gehäuse nach einem der Ansprüche 1 bis 9, dadurch gekennzeichnet, daß es parallelepipedisch ist, wobei sein Boden (40) die Form eines Quadrats oder einer Raute besitzt.

11. Gehäuse nach einem der Ansprüche 1 bis 10, dadurch gekennzeichnet, daß es aus einem thermoplastischem Material durch Spritzguß hergestellt wird.

## Claims

1. Housing for the encapsulation of an electronic component (50), including a bottom (40), side faces (41) carrying means (48) for guiding connection leads (45) of the component (50), these faces being arranged around a principal axis of the housing, characterized in that the bottom (40) has sides all equal and in that the side faces (41) all include guide means (48), the guide means (48) being uniformly distributed about the principal axis of the housing.

2. Housing according to Claim 1, characterized in that each side face (41) includes at least one washing foot (49).

3. Housing according to Claim 2, characterized in that the washing feet (49) are uniformly distributed about the principal axis.

4. Housing according to one of Claims 1 to 3, characterized in that the guide means (48) are placed inside the housing (50).

5. Housing according to one of Claims 1 to 4, characterized in that the guide means (48) are arranged in the central portion of each side face (41).

6. Housing according to one of Claims 1 to 4, characterized in that the guide means (48) are arranged in the region of edges (51) separating two successive side faces (41).

7. Housing according to one of Claims 1 to 6, characterized in that the guide means have the shape of a groove (52) directed along the principal axis of the housing.

8. Housing according to one of Claims 2 to 7, characterized in that the washing feet (49) form projections which extend the side faces (41) beyond an open face (42) of the housing, opposite its bottom (40).

9. Housing according to one of Claims 2 to 8, characterized in that the washing feet (49) are remote from edges (51) separating two successive side faces (41) in order, when the housing is filled with a liquid resin, to prevent the latter from wicking up along the washing feet (49) by capillarity.

10. Housing according to one of Claims 1 to 9, characterized in that it is parallelepipedal, its bottom (40) having the shape of a square or a rhombus.

11. Housing according to one of Claims 1 to 10, characterized in that it is made from a thermoplastic material, by moulding.
